Europäisches Patentamt

European Patent Office

Office européen des brevets

(19)

(11) Numéro de publication : **0 034 102**
**B1**

(12) FASCICULE DE BREVET EUROPÉEN

(45) Date de publication du fascicule du brevet :
05.09.84

(51) Int. Cl.³ : **H 01 G   4/40**, H 01 L 25/14

(21) Numéro de dépôt : **81400190.5**

(22) Date de dépôt : **06.02.81**

(54) Multiplicateur de tension intégré.

(30) Priorité : **12.02.80 FR 8003046**

(43) Date de publication de la demande :
**19.08.81 Bulletin 81/33**

(45) Mention de la délivrance du brevet :
**05.09.84 Bulletin 84/36**

(84) Etats contractants désignés :
**DE GB IT**

(56) Documents cités :
**FR-A- 1 587 785**
**FR-A- 2 437 688**
**US-A- 3 544 925**
**US-A- 3 900 788**

(73) Titulaire : **THOMSON-CSF**
**173, Boulevard Haussmann**
**F-75379 Paris Cedex 08 (FR)**

**L.C.C.-C.I.C.E. - COMPAGNIE EUROPEENNE DE**
**COMPOSANTS ELECTRONIQUES**
**101, Boulevard Murat**
**F-75781 Paris Cedex 16 (FR)**

(72) Inventeur : **Morel, Gilbert**
**THOMSON-CSF SCPI 173, bld Haussmann**
**F-75360 Paris Cedex 08 (FR)**
Inventeur : **Frappart, Pierre**
**THOMSON-CSF SCPI 173, bld Haussmann**
**F-75360 Paris Cedex 08 (FR)**
Inventeur : **Saint Marcoux, Roland**
**THOMSON-CSF SCPI 173, bld Haussmann**
**F-75360 Paris Cedex 08 (FR)**

(74) Mandataire : **Vesin, Jacques et al**
**THOMSON-CSF SCPI 173, Bld Haussmann**
**F-75379 Paris Cedex 08 (FR)**

Jouve, 18, rue St-Denis, 75001 Paris, France

## Description

La présente invention concerne des multiplicateurs de tension dits intégrés, c'est-à-dire réalisés suivant la technologie dite multicouche.

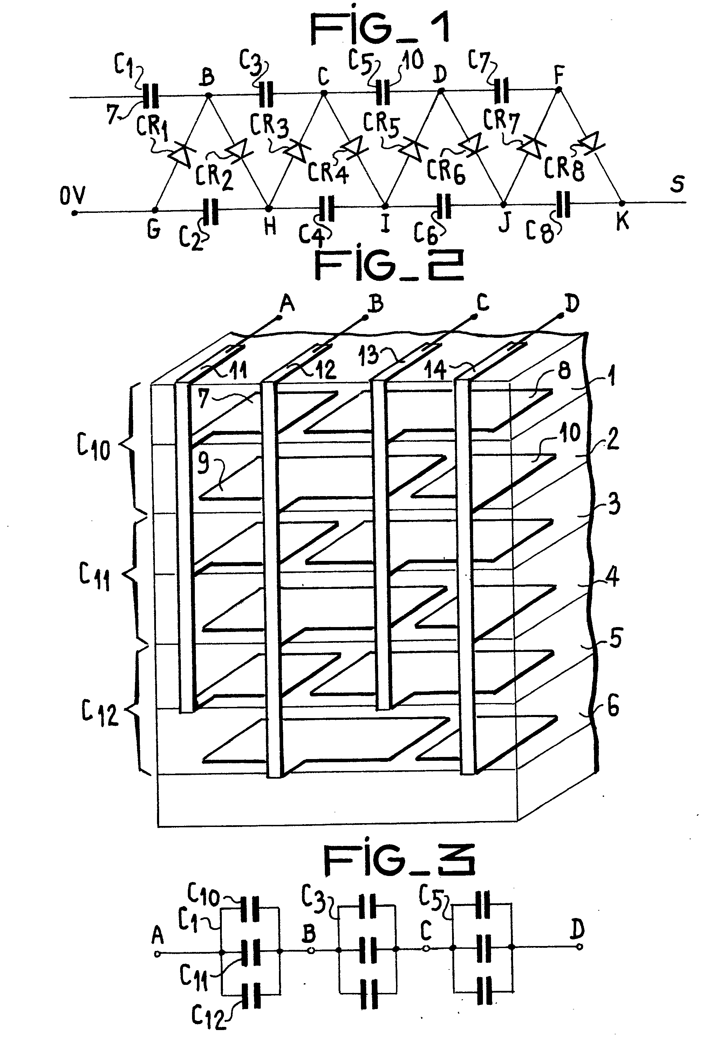

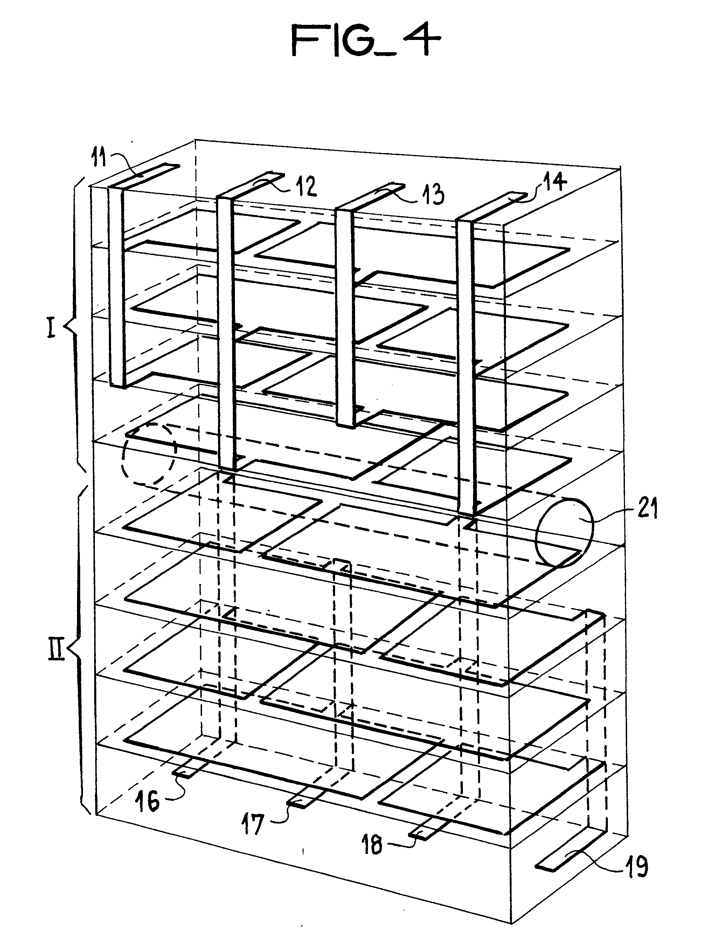

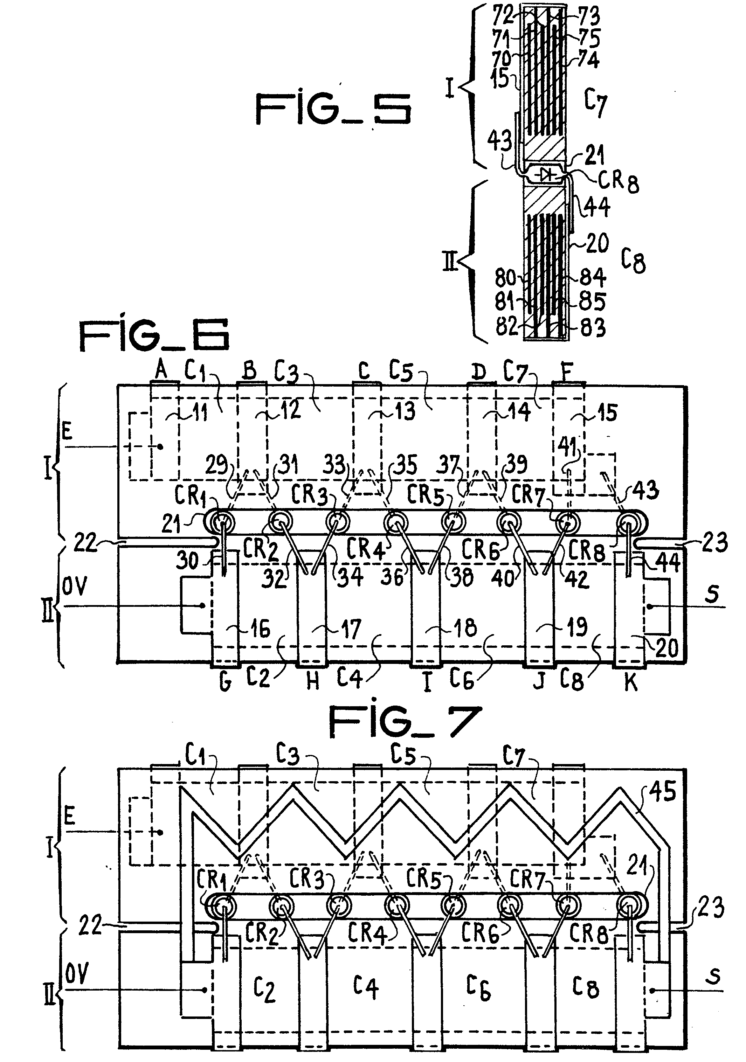

Les multiplicateurs de tension à plusieurs étages, tels que celui représenté schématiquement figure 1 sont constitués par une association en cascade de condensateurs et de diodes et leur réalisation, jusqu'à présent, a pris plusieurs formes suivant le choix qui a été fait de leurs éléments constitutifs.

Ces éléments sont, d'une part, des capacités élémentaires constituées le plus souvent par des condensateurs à diélectrique céramique, sous forme de disque monolithique ou multicouche, ou à diélectrique film et de diodes. Ces éléments sont disposés en série comme le montre la figure 1 qui représente un multiplicateur de tension connu sous le nom d'échelle de Greinacher. Les capacités utilisées peuvent être également obtenues par métallisation de chacune des faces d'une plaque isolante, céramique ou époxy par exemple, avec des dispositions telles que l'on puisse obtenir une série de plusieurs condensateurs dont les caractéristiques, liées à la tension et à la fréquence de l'alimentation ainsi qu'à la tension et à la fréquence de l'alimentation ainsi qu'à la tension et au débit de la sortie sont semblables.

Pour réaliser actuellement un multiplicateur de tension, on utilise donc des composants actifs et passifs qui sont assemblés suivant le schéma du montage du multiplicateur, puis surmoulés, le multiplicateur se présentant sous la forme d'un bloc et dans lequel voisinent différents matériaux. De tels multiplicateurs sont par exemple décrits dans les brevets US-A-3 900 788 et FR-A-1 587 785.

Cette disposition présente des inconvénients provoqués par le comportement différent de ces matériaux aux conditions climatiques. De fait, le verre des diodes, le cuivre et l'étain-plomb des connexions et des soudures, la céramique ou le film des condensateurs, ainsi que la résine de protection réagissent de façon fort différente aux conditions climatiques et au vieillissement, qui sous l'influence de différentes contraintes thermiques, provoquent une modification des caractéristiques entraînant une dégradation des performances. Il faut également tenir compte de la très haute tension qui, à l'intérieur du bloc, risque de provoquer des lignes de fuite créant des court-circuits d'éléments constitutifs du multiplicateur.

A ces inconvénients, vient s'ajouter celui de l'encombrement et du volume occupé par le bloc que constitue le multiplicateur qui présente actuellement des dimensions relativement importantes peu compatibles avec ce qui est réclamé dans certaines applications, comme par exemple le balayage de la visualisation radar principalement dans la version embarquée. De fait, il n'apparaît pas facile de réduire le volume des multiplicateurs de tension actuellement réalisés étant donné qu'il serait nécessaire d'agir sur le volume de chaque composant, dont la somme augmentée des espaces nécessaires à l'isolement de chacun d'eux, donne précisément le volume global du bloc multiplicateur.

Un objet de l'invention est donc la réalisation d'un multiplicateur de tension échappant aux inconvénients signalés dans ce qui précède.

Suivant l'invention, pour obtenir une diminution du volume du multiplicateur de tension, on agit plus particulièrement sur les condensateurs que l'on réalise sous la forme d'un bloc homogène, fabriqué par application de la technologie dite multicouche.

Suivant l'invention, un multiplicateur de tension intégré constitué par au moins deux groupes indépendants de condensateurs montés en série, et des diodes interconnectant les condensateurs des deux groupes, réalisé sous la forme d'un bloc monolithique comprenant au moins les deux groupes de condensateurs indépendants, chaque groupe étant réalisé suivant la technologie dite multicouche est caractérisé en ce que les armatures ou électrodes des condensateurs sont constitués par des zones métallisées de surfaces différentes, les unes de surface simple, les autres de surface double, formées sur des feuilles minces de diélectriques céramique, que les zones de surface double représentent des armatures en série de deux condensateurs successifs, que les feuilles minces métallisées, empilées les unes sur les autres sont telles que les armatures se trouvent placées en regard les unes par rapport aux autres, et qu'une métallisation partielle extérieure au bloc de condensateurs réalise les connexions entre les différentes armatures en parallèle desdits condensateurs.

Suivant l'invention également, le multiplicateur de tension intégré comprend, établie en creux, dans la partie du bloc située entre les deux groupes de condensateurs, un logement destiné aux diodes interconnectant les condensateurs des deux groupes.

D'autres avantages et caractéristiques ressortiront de la description qui suit, d'un exemple de réalisation donné à l'aide des figures qui représentent :

la figure 1 un schéma de principe électrique d'un multiplicateur de tension à plusieurs étages du type échelle de Greinacher ;

la figure 2 une vue dans l'espace d'un bloc de condensateurs réalisé suivant l'invention ;

la figure 3 le schéma électrique équivalent du bloc de la figure 2 ;

la figure 4 une vue de la structure intégrée d'un multiplicateur dans l'espace d'un bloc de deux groupes de condensateurs réalisé conformément à l'invention ;

la figure 5 un schéma de montage d'une diode dans un bloc de condensateurs ;

la figure 6 un multiplicateur de tension intégré, complet, conforme à l'invention, et

la figure 7 un multiplicateur de tension intégré complet avec une résistance de charge également intégrée.

Comme cela a été mentionné dans l'introduction à la présente description, on recherche dans de nombreux cas d'utilisation de multiplicateurs de tension, outre la disparition des inconvénients liés aux réalisations actuelles de multiplicateurs et qui sont dus à la présence dans un même bloc de différents matériaux ayant des comportements différents dans les conditions d'utilisation apportant des contraintes d'ordre thermique et/ou électrique et vis-à-vis du vieillissement, une miniaturisation des ensembles.

Les multiplicateurs de tension à plusieurs étages étant des assemblages de condensateurs et de diodes, tel celui de la figure 1 par exemple, et le volume total d'un multiplicateur étant la somme des volumes de ses composants à laquelle il faut ajouter des espaces nécessaires à l'isolement de chacun de ses composants, il a paru judicieux d'agir, pour la miniaturisation, sur l'ensemble des composants occupant le volume le plus important, c'est-à-dire sur les condensateurs. Si on se reporte à la figure 1, qui représente le schéma électrique d'un multiplicateur de tension à plusieurs étages, dit échelle de Greinacher, on remarque qu'un tel multiplicateur comprend deux groupes de condensateurs, C1, C3, C5, C7 montés en série et C2, C4, C6, C8 montés également en série, et que des diodes CR1, CR2 ... CR8 sont disposées entre les deux groupes de condensateurs de chacun des groupes. Une réduction du volume de chacun des groupes des condensateurs doit conduire à une réduction du volume total, les diodes étant disposées dans l'espace existant entre les deux groupes de condensateurs.

Suivant l'invention, on réalise, en utilisant la technologie dite multicouche, un bloc monolithique de condensateurs, comportant au moins deux groupes de condensateurs montés en série et indépendants l'un de l'autre, et disposés l'un par rapport à l'autre de façon telle que l'espace existant entre les deux groupes de condensateurs est utilisable pour abriter les diodes connectées entre eux.

La figure 2 représente sous la forme d'un bloc céramique, un groupe de condensateurs montés en série, et réalisé suivant la technologie multicouche. On utilise pour fabriquer un groupe de tels condensateurs des feuilles minces de diélectrique, de l'ordre par exemple de 20 à 150 µm présentant une tenue en tension par millimètre suffisante pouvant être de l'ordre de 5 à 10 fois supérieure à celle des diélectriques massifs de forte épaisseur supérieur au millimètre utilisés actuellement pour fabriquer des condensateurs. Ces feuilles minces de diélectrique céramique sont métallisées, à l'aide de palladium, d'argent-palladium, d'or-palladium, de nickel, ou autres métaux, suivant une disposition propre à créer plusieurs condensateurs, puis empilées, et pressées de façon à donner un bloc monolithique comportant en son intérieur un groupe de condensateurs montés en série. Le schéma électrique équivalent est montré figure 3. On remarque sur ce schéma que chaque condensateur, soit C1, C3 et C5 est constitué par plusieurs condensateurs élémentaires, trois dans l'exemple décrit, C10, C11, C12 montés en parallèle, ceci pour la raison qu'un seul condensateur ne pourrait avoir la valeur de capacité nécessaire. La métallisation de chaque feuille de diélectrique céramique telle que 1, 2, ... 5, 6 consiste à créer au moins dans l'exemple décrit, deux zones métalliques 7 et 8 de surface différente sur la feuille 1 et 9-10 sur la feuille 2. La zone 7 apparaît comme un carré et la zone 8 comme un rectangle de surface double. La zone 7 constitue une armature d'un condensateur élémentaire constituant elle-même l'armature extérieure du condensateur C1, repérée par le chiffre 7, tandis que la zone 8, de surface double, représente l'ensemble des armatures en série du condensateur C3 et du condensateur C5. De façon semblable la zone 9 rectangulaire de surface double de la zone 10 représente l'ensemble des armatures en série des condensateurs C1 et C3, tandis que la zone 10 représente l'armature de droite du condensateur C5. Ces schémas sont reproduits alternativement sur chacune des feuilles 3, 4, 5 et 6 par exemple. Au moment de l'empilage des feuilles ainsi métallisées des deux types, on met en place, de façon correcte les armatures des condensateurs C1, C3 et C5. Après l'empilage, c'est-à-dire après que les feuilles de diélectrique céramique aient été mises en place et les condensateurs formés, on établit les connexions entre les différentes armatures des condensateurs élémentaires et on les ramène sur les faces du bloc par une métallisation extérieure ainsi que cela est parfaitement visible sur la figure 2. La métallisation 11 représente la connexion entre la borne d'entrée A et la première armature, de gauche sur la figure 3, du condensateur C1, la métallisation 12 représente la connexion entre l'armature de droite du condensateur C1 et l'armature de gauche du condensateur C3 aboutissant au point B, la métallisation 13 représente la connexion entre l'armature de droite du condensateur C3 et l'armature de gauche du condensateur C5, aboutissant au point C et la métallisation 14 représente la connexion entre l'armature de droite du condensateur C5 et la borne de sortie du groupe de condensateurs imagé sur la figure 2.

Il est évident qu'un autre groupe de condensateurs semblable à celui de la figue 2 peut être réalisé de la même manière pouvant constituer un autre bloc de condensateurs indépendant de celui du premier groupe ; les deux groupes peuvent également être disposés dans le même bloc. Ce bloc, tel que montré figure 4, représente dans l'espace deux groupes de condensateurs montés en série, en l'occurrence les groupes de condensateurs C1-C3-C5 d'une part et C2-C4-C6 d'autre part de la figure 1 avec leurs connexions 16, 17, 18 et 19. Entre les blocs I et II, on a indiqué les emplacements que peuvent occuper les diodes dans le bloc. Ceci dans le but également de limiter au maximum le volume du multiplicateur.

De fait, le bloc de la figure 4 ne présente qu'une étape intermédiaire dans la fabrication d'un multiplicateur intégré suivant l'invention. Comme le montre le schéma de la figure 1 les deux groupes de condensateurs sont reliés par des diodes CR1 à CR8. Celles-ci doivent être disposées entre les groupes de condensateurs de façon à être soumises à une valeur de champ électrique bien définie et la plus faible possible dans les conditions de fonctionnement du multiplicateur, valeur de champ supportable. Bien que ces diodes puissent être connectées correctement alternativement aux deux groupes de condensateurs en restant à l'extérieur du bloc, il a paru être une meilleure solution, suivant l'invention, de disposer les diodes dans un logement prévu à cet effet dans les blocs de condensateurs.

La figure 6 représente vu de côté, en plan, un multiplicateur de tension intégré. On remarque le premier groupe 1 des condensateurs C1, C3, C5, C7 avec les métallisations extérieures sur lesquelles on a référencé des bornes A, B, C, D, F, la borne d'entrée E connectée au condensateur C1 et la borne de tension nulle OV connectée au condensateur C2 du deuxième groupe. Le deuxième groupe II des condensateurs C2, C4, C6 et C8, a été réalisé sous le premier groupe et légèrement décalé par rapport à lui et le dernier condensateur C8 est connecté à la borne de sortie S du multiplicateur. Les métallisations extérieures 16, 17, 18, 19 et 20 semblables à celles 11 à 15 du premier groupe sont visibles sur la figure et on y a repéré les bornes G, H, I, J et K correspondant à celles de la figure 1. Pour loger les diodes CR1 à CR8 dans le bloc on a prévu un logement 21 dont l'emplacement entre les deux groupes de condensateurs a été choisi de la façon indiquée, c'est-à-dire dans une zone où le champ électrique est non seulement bien défini et stable, mais aussi le plus faible possible, de sorte que les diodes supportent toutes des tensions identiques et constantes, ce qui peut avoir pour effet d'augmenter leur durée de vie. Ce logement 21 se présente sous la forme d'une fente longitudinale pratiquée dans le bloc des condensateurs, avec des diodes fixées dans la fente ; de préférence les diodes sont collées. Pour diminuer l'influence des capacités parasites d'entrée surtout et de sortie qui, fonction de la constante diélectrique du diélectrique du bloc et de la fréquence peuvent atteindre des valeurs non négligeables, on prévoit dans le bloc, deux autres fentes 22 et 23 fines, placées de part et d'autre de la fente 21 et d'axes longitudinaux décalés par rapport à l'axe de la fente 21. Ces fentes coupant les lignes de force des capacités permettant de ramener les capacités d'entrée et de sortie du multiplicateur à des valeurs normales. Ce logement peut également se présenter sous la forme de trous, chacun abritant une diode. Pour les mêmes raisons que celles évoquées précédemment, on prévoit une fente fine longitudinale dans le bloc.

La figure 5 montre de façon schématique comment les diodes sont disposées dans le bloc de diélectrique céramique. Celui-ci est vu par la tranche et on reconnaît un condensateur C7 par exemple, du premier groupe I et C8 du deuxième groupe II par leurs armatures 70 à 75 et 80 à 85. Entre les deux condensateurs, se trouve le logement 21 dans lequel est placée une diode, dans l'exemple retenu, la diode CR8 dont les bornes sont connectées aux métallisations extérieures 15 d'une part et 19 d'autre part, respectivement par les connexions 43 et 44. Comme on le voit clairement sur la figure 6, les autres diodes placées respectivement dans la fente 21 qui leur sert de logement sont connectées aux différents condensateurs des deux groupes suivant le schéma de la figure 1. Ainsi, la diode CR1 est connectée aux armatures en série des condensateurs C1 et C3 (point B) par sa connexion 29 et au condensateur C2 (borne G) par sa connexion 30. La diode CR2 est connectée par sa connexion 31 à la borne B également et par sa connexion 32 à la métallisation 17 (borne 4). Il en est de même pour les diodes suivantes CR3, CR4, CR5, CR6 et CR7 par leurs connexions 33-34 ; 35-36 ; 37-38 ; 39-40 ; 41-42 ; La fente 21 servant de logement aux diodes est établie au cours du processus de fabrication du bloc homogène, quand la céramique est encore pâteuse. Cette solution est préférable à celle consistant à usiner le bloc achevé. On évite en particulier le risque de microfélures.

La figure 7 représente une vue complète du multiplicateur de tension intégré suivant l'invention, comportant une résistance de charge à haute impédance 45, obtenue au cours d'une opération préfinale, par dépôt d'une couche résistive sur l'une des faces du bloc. Cette résistance est utilisée comme pont atténuateur de mesure et bleeder de décharge. De plus, l'isolement entre les divers points de la résistance et les différentes parties du multiplicateur est réduit, les parties en présence étant sensiblement au même potentiel.

L'opération finale de la fabrication du multiplicateur intégré consiste à recouvrir le bloc d'une fine couche de silicone, d'époxy ou encore d'émail.

On a ainsi décrit le processus de fabrication d'un multiplicateur de tension dit intégré suivant la technologie dite multicouche et le multiplicateur ainsi que le bloc des condensateurs, celui-ci à titre de produit intermédiaire, que l'on obtient ainsi.

On peut donner les avantages d'une telle réalisation.

Un bloc de condensateurs dont les dimensions sont 50 × 25 × 3 mm, pourra comprendre deux séries de quatre condensateurs ayant pour valeur unitaire 2,5 nF avec une tension de source de l'ordre de 2,5 Kv. Un ensemble intégré complet de 75 × 25 × 3 mm pourra fournir une tension de sortie de l'ordre de 20 Kv, occupant un volume de 4 à 6 fois moindre que le volume d'un multiplicateur de même performance de l'art antérieur. Outre cette réduction en volume, le multiplicateur intégré présente une meilleure stabilité en tension et température. De fait, le diélectrique et le mode opératoire étant les mêmes pour tous les condensateurs, les dérives vont dans le même sens et sont de même valeur, et les diodes, on le rappelle, sont soumises à des tensions identiques et constantes.

On peut noter que la tolérance sur la capacité est meilleure que + 5 %. Le surmoulage consistant en une mince pellicule de résine diminue les contraintes aléatoires provoquant des défauts. Les connexions sont réduites le plus possible et la simplification de leur forme tendent à éliminer les champs parasites et partant à augmenter la fiabilité.

De plus, il est aisé dans un même bloc d'obtenir des capacités de valeurs différentes. Enfin, la reproductibilité de la fabrication est assurée.

Quant à l'utilisation de tels multiplicateurs intégrés, elle s'impose plus particulièrement dans les cas où la recherche de la miniaturisation domine ainsi que la durée de vie et la fiabilité.

On pourra citer à titre d'exemple, les dispositifs de balayage d'une visualisation radar embarquée, les caméras de télévision portatives, les oscilloscopes.

## Revendications

1. Multiplicateur de tension intégré constitué par au moins deux groupes (I, II) indépendants de condensateurs (C1 à C8) montés en série, et les diodes (CR1 à CR8) interconnectant les condensateurs des deux groupes, réalisé sous la forme d'un bloc monolithique comprenant au moins les deux groupes (I, II) de condensateurs indépendants, chaque groupe étant réalisé suivant la technologie dite multicouche, caractérisé en ce que les armatures ou électrodes (7, 8, 9, 10) des condensateurs sont constituées par des zones métallisées de surfaces différentes, les unes de surface simple, les autres de surface double, formées sur des feuilles minces de diélectriques céramiques (1 à 6), que les zones de surface double représentent l'ensemble des armatures en série de deux condensateurs successifs, que les feuilles minces métallisées empilées les unes sur les autres sont telles que les armatures se trouvent placées en regard les unes par rapport aux autres, et qu'une métallisation partielle extérieure du bloc de condensateurs réalise les connexions (11 à 20) entre les différentes armatures en parallèle desdits condensateurs.

2. Multiplicateur de tension intégré réalisé suivant la revendication 1, caractérisé par le fait qu'il comprend dans l'espace entre les deux groupes indépendants de condensateurs en série, une ou plusieurs fentes (21, 22, 23) occupant tout ou partie de la longueur du bloc, servant l'une (21) de logement aux diodes (CR1 à CR8) interconnectant les condensateurs des deux groupes, et les autres (22, 23) agissant sur les capacités parasites d'entrée et de sortie du multiplicateur.

3. Multiplicateur de tension suivant la revendication 1, caractérisé par le fait qu'il comprend dans l'espace entre les deux groupes indépendants de condensateurs en série, des trous servant de logement aux diodes interconnectant les condensateurs des deux groupes et une fente fine longitudinale (22, 23) occupant tout ou partie de la longueur du bloc prévu pour agir sur les capacités parasites d'entrée et de sortie du multiplicateur.

4. Multiplicateur de tension suivant des revendications 1, 2 ou 3, caractérisé par le fait qu'il est constitué par deux groupes de condensateurs réalisés sous la forme de deux blocs indépendants.

5. Multiplicateur de tension suivant l'une des revendication 1, 2 ou 3, caractérisé par le fait qu'il comprend en outre une couche résistive sur l'une des faces du bloc, constituant une résistance de charge (45).

6. Multiplicateur de tension intégré, réalisé sous la forme d'un bloc monolithique suivant l'une des revendications précédentes, caractérisé par le fait qu'il comprend un premier groupe (I) de condensateurs montés en série, réalisés sur une feuille de diélectrique céramique, un second groupe (II) de condensateurs montés en série, réalisés sur une feuille de diélectrique céramique, chaque condensateur (C1 à C8) des deux groupes étant constitué par un certain nombre de condensateurs élémentaires (C10, C11, C12) montés en parallèle, des diodes (CR1 à CR8) disposées dans le bloc dans une zone entre les deux groupes de condensateurs où le champ électrique est bien défini, constant et le plus faible possible, dans un logement prévu à cet effet (21), lesdites diodes étant connectées aux condensateurs des deux groupes en des points (A, B, C, D, E, F, G, H, I, J, K) ramenés par métallisation extérieure (11, 12, 13, 14, 15, 16, 17, 18, 19) sur les faces du bloc.

7. Multiplicateur de tension intégré, suivant la revendication 6, caractérisé par le fait qu'il comprend, associées au logement des diodes réalisé suivant une fente longitudinale (21) ou des trous disposés sur la longueur du bloc, une ou plusieurs fentes fines longitudinales (22, 23) agissant sur les capacités d'entrée et de sortie du multiplicateur.

8. Multiplicateur de tension intégré, suivant la revendication 6, caractérisé par le fait qu'il comprend une résistance de charge intégrée (45).

9. Multiplicateur de tension intégré, suivant l'une des revendications 1 à 8, caractérisé en ce qu'une zone (8, 9) métallisée sur deux (7, 10) constitue une armature commune à deux condensateurs montés en série.

10. Procédé de réalisation d'un multiplicateur de tension intégré sous la forme d'un bloc monolithique constitué par au moins deux groupes (I, II) indépendants de condensateurs (C1 à C8) montés en série et des diodes (CR1 à CR8) interconnectant les condensateurs des deux groupes, caractérisé en ce que

— on réalise chacun des deux groupes de condensateurs suivant la technologie dite multicouche, par métallisation de feuilles minces de diélectrique céramique (1 à 6), telle que chaque face d'une feuille porte un certain nombre de zones métallisées (7, 8, 9, 10) de surfaces différentes, les unes de surface simple, les autres de surface double, constituant des armatures ou électrodes de condensateurs, les zones de surface double représentant l'ensemble des armatures en série de deux condensateurs successifs,

— on empile les feuilles minces métallisées de manière telle que les armatures se trouvent placées en regard les unes par rapport aux autres,

— on réalise des connexions (11 à 20) entre les différentes armatures en parallèle par une métallisation partielle extérieure du bloc monolithique de condensateurs,

— on établit dans l'espace entre les deux groupes (I, II) indépendants de condensateurs en série une ou plusieurs fentes (21, 22, 23) occupant tout ou partie de la longueur du bloc, l'une (21) pour le logement des diodes (CR1 à CR8) interconnectant les condensateurs des deux groupes et les autres (22, 23) agissant sur les capacités parasites d'entrée et de sortie du multiplicateur,

— on dépose suivant la technologie dite « couche épaisse » une couche résistive sur l'une des faces du bloc, constituant une résistance de charge (45) à haute impédance,

— on enrobe le bloc d'une fine couche de silicone, d'époxy ou d'émail.

11. Procédé suivant la revendication 10, caractérisé en ce que, dans l'espace entre les deux groupes indépendants de condensateurs en série, on réalise des trous pour servir de logement aux diodes (CR1, CR8).

**Claims**

1. An integrated voltage multiplier, consisting of at least two independent groups (I, II) of series connected capacitors (C1 to C8) and of diodes (CR1 to CR8) interconnecting the capacitors of said two groups, the multiplier being constituted by a monolithic block which comprises at least the two groups (I, II) of independent capacitors, each group being made in accordance with the multilayer technology, characterized in that the plates or electrodes (7, 8, 9, 10) are constituted by metallized zones of different surfaces, some of them being simple surfaces and others double surfaces, applied on thin foils of a dielectric ceramic material (1 to 6), that the zones of double surface represent the set of the series connected plates of two successive capacitors, that the thin metallized foils which are stacked one on the other are made in such a way, that the plates are placed one in face of the other and that a partial outer metallization of the block of capacitors constitutes the connection (11 to 20) between the different parallel plates of said capacitors.

2. An integrated voltage multiplier according to claim 1, characterized in that it comprises in the space between the two independent groups of series connected capacitors one or several slots (21, 22, 23) which occupy the entire length of the block or a part thereof, one of the slots (21) housing the diodes (CR1 to CR8) which interconnect the capacitors of the two groups and the other slots (22, 23) acting on the parasitic input and output capacitances of the multiplier.

3. An integrated voltage multiplier according to claim 1, characterized in that it comprises, in the space between the two independent groups of series connected capacitors, holes for housing the diodes which interconnect the capacitors of the two groups, and a narrow longitudinal slot (22, 23) which occupies the entire length of the block or part thereof in order to act on the parasitic input and output capacitances of the multiplier.

4. An integrated voltage multiplier according to one of the claims 1, 2 or 3, characterized in that it is constituted by two groups of capacitors made of two independent blocks.

5. An integrated voltage multiplier according to one of the claims 1, 2 or 3, characterized in that it further comprises a resistive layer on one of the faces of the block, this layer constituting a load resistor (45).

6. An integrated voltage multiplier made of a monolithic block according to one of the preceding claims, characterized in that it comprises a first group (I) of series connected capacitors which are realized on a dielectric ceramic foil, a second group (II) of series connected capacitors which are made on a foil of dielectric ceramic material, each capacitor (C1 to C8) of the two groups consisting of a certain number of parallelly connected elementary capacitors (C10, C11, C12), diodes (CR1 to CR8) disposed in the block in a zone between the two capacitor groups in which zone the electric field is well defined and constant and as low as possible, in an adapted housing (21), said diodes being connected to the capacitors of the two groups in points (A, B, C, D, E, F, G, H, I, J, K) which are transferred by an outer metallization (11, 12, 13, 14, 15, 16, 17, 18, 19) on the faces of the block.

7. An integrated voltage multiplier according to claim 6, characterized in that it comprises one or more narrow longitudinal slots (22, 23) acting on the input and output capacitances of the multiplier, these slots being associated to the housing of the diodes which is realized according to a longitudinal slot (21) or to holes disposed along the length of the block.

8. An integrated voltage multiplier according to claim 6, characterized in that it comprises an integrated load resistor (45).

9. An integrated voltage multiplier according to one of the claims 1 to 8, characterized in that one out of two metallized zones (8, 9, 7, 10) constitutes a common plate of two series connected capacitors.

10. A method for making an integrated voltage multiplier as a monolithic block of at least two independent groups (I, II) of series connected capacitors (C1 to C8) and of diodes (CR1 to CR8) interconnecting the capacitors of the groups, characterized in that it comprises the following steps :

— each of the two groups of capacitors is made in accordance with the multilayer technology by metallization of thin foils of dielectric ceramic material (1 to 6) in such a way that each face of one foil bears a certain number of metallized zones (7, 8, 9, 10) of different surfaces, some of the surfaces being simple surfaces and others being double surfaces, constituting the plates or electrodes of capacitors, the zones of double surface representing the set of series-connected plates of two successive capacitors,

— the thin metallized foils are stacked in such a way that the plates present a face to face relationship with one another,

— connections (11 to 20) are made between the different parallel armatures by a partial outer metallization of the monolithic block of the capacitors,

— one or more slots (21, 22, 23) are realized in the space between the two independent groups (I, II) of series-connected capacitors, these slots occupying the entire length of the block or a part thereof, one of the slots (21) being conceived to house the diodes (CR1 to CR8) which interconnect the capacitors of the two groups, whereas the others (22, 23) act on the parasitic input and output capacitances of the multiplier,

— a resistive layer is applied to one of the block faces in accordance with the thick layer technology, this layer constituting a high impedance load resistor (45),

— the block is surrounded by a thin layer of silicone, epoxy or enamel.

11. A method according to claim 10, characterized in that holes are made in the space between the two independent groups of series-connected for housing the diodes (CR1, CR8).

**Ansprüche**

1. Integrierter Spannungsvervielfacher, bestehend aus mindestens zwei unabhängigen Gruppen (I, II) von in Reihe geschalteten Kondensatoren (C1 bis C8) und aus Dioden (CR1 bis CR8), die die Kondensatoren der beiden Gruppen miteinander verbinden, in Form eines monolytischen Blocks, der mindestens die beiden Gruppen (I, II) von unabhängigen Kondensatoren enthält, wobei jede Gruppe gemäß der sogenannten Vielschicht-Technologie hergestellt ist, dadurch gekennzeichnet, daß die Platten oder Elektroden (7, 8, 9, 10) der Kondensatoren von metallisierten Zonen unterschiedlicher Oberfläche gebildet werden, von denen die einen einfache und die anderen doppelte Oberflächen bilden und auf dünnen Folien einer dielektrischen Keramik (1 bis 6) ausgebildet sind, daß die Zonen doppelter Oberfläche alle Reihenplatten von zwei aufeinanderfolgenden Kondensatoren darstellen, daß die dünnen metallisierten Folien, die übereinandergestapelt sind, so angeordnet sind, daß die Platten einander gegenüberliegen, und daß eine Metallisierung eines Teils der Außenfläche des Blocks die Verbindungen (11 bis 20) zwischen den verschiedenen parallelen Platten der Kondensatoren herstellen.

2. Integrierter Spannungsvervielfacher nach Anspruch 1, dadurch gekennzeichnet, daß im Zwischenraum zwischen den beiden unabhängigen Gruppen von in Reihe geschalteten Kondensatoren ein Spalt oder mehrere Spalte (21, 22, 23) vorgesehen sind, die die ganze Länge des Blocks oder einen Teil davon einnehmen und von denen der eine zur Aufnahme der Dioden (CR1 bis CR8) dient, die die Kondensatoren der beiden Gruppen miteinander verbinden, während die anderen Spalte (22, 23) auf die parasitären Eingangs- und Ausgangskapazitäten des Vervielfachers einwirken.

3. Integrierter Spannungsvervielfacher nach Anspruch 1, dadurch gekennzeichnet, daß im Zwischenraum zwischen den beiden unabhängigen Gruppen von in Reihe geschalteten Kondensatoren Löcher, die zur Aufnahme der die Kondensatoren der beiden Gruppen miteinander verbindenden Dioden dienen, und ein feiner Längsspalt (22, 23) vorgesehen sind, der die ganze Länge des Blockes oder ein Teil davon einnimmt und auf die parasitären Eingangs- und Ausgangskapazitäten des Vervielfachers einwirken soll.

4. Integrierter Spannungsvervielfacher nach einem der Ansprüche 1, 2 oder 3, dadurch gekennzeichnet, daß er von zwei Gruppen von Kondensatoren gebildet wird, die in Form von zwei voneinander unabhängigen Blöcken realisiert sind.

5. Integrierter Spannungsvervielfacher nach einem der Ansprüche 1, 2 oder 3, dadurch gekennzeichnet, daß er außerdem eine Widerstandsschicht aufweist, die auf eine der Oberflächen des Blocks aufgebracht ist und einen Lastwiderstand (45) bildet.

6. Integrierter Spannungsvervielfacher, der als monolytischer Block nach einem der vorhergehenden Ansprüche hergestellt ist, dadurch gekennzeichnet, daß er eine erste Gruppe (I) von in Reihe geschalteten Kondensatoren, die auf einer Folie eines dielektrischen Keramikmaterials aufgebracht sind, und eine zweite Gruppe (II) von in Reihe geschalteten Kondensatoren enthält, die auf einer Folie eines dielektrischen Keramikmaterials aufgebracht sind, wobei jeder Kondensator (C1 bis C8) der beiden Gruppen von einer gewissen Anzahl von parallelgeschalteten Elementarkondensatoren (C10, C11, C12) gebildet wird und Dioden (CR1 bis CR8) in dem Block in einer Zone zwischen den beiden Gruppen von Kondensatoren, wo das elektrische Feld sehr genau definiert ist, d. h. konstant und möglichst klein, und zwar an einem hierfür vorgesehenen Platz (21) angeordnet sind, die mit den Kondensatoren der beiden Gruppen in Punkten (A, B, C, D, E, F, G, H, I, J, K) verbunden sind, welche durch Außenmetallisierung (11, 12, 13, 14, 15, 16, 17, 18, 19) auf die Oberflächen des Blocks herausgeführt sind.

7. Integrierter Spannungsvervielfacher nach Anspruch 6, dadurch gekennzeichnet, daß ein Spalt oder mehrere feine Längsspalte (22, 23) zur Einwirkung auf die Eingangs- und Ausgangskapazitäten des Vervielfachers vorgesehen sind, die dem Platz, an dem die Dioden liegen und der aus einem Längsspalt (21) oder in Längsrichtung des Blocks verlaufenden Löchern gebildet wird, zugeordnet sind.

8. Integrierter Spannungsvervielfacher nach Anspruch 6, dadurch gekennzeichnet, daß er einen integrierten Lastwiderstand (45) enthält.

9. Integrierter Spannungsvervielfacher nach einem der Ansprüche 1 bis 8, dadurch gekennzeichnet, daß eine metallisierte Zone (8, 9) von je zwei Zonen (7, 10) eine gemeinsame Platte für zwei in Reihe geschaltete Kondensatoren bildet.

10. Verfahren zur Herstellung eines integrierten Spannungsvervielfachers in Form eines monolytischen Blocks, bestehend aus mindestens zwei unabhängigen Gruppen (I, II) von in Reihe geschalteten Kondensatoren (C1 bis C8) und aus Dioden (CR1 bis CR8), welche die Kondensatoren der beiden Gruppen miteinander verbinden, dadurch gekennzeichnet, daß

— man jede der beiden Gruppen von Kondensatoren nach der sogenannten Vielschichttechnologie durch Metallisierung von dünnen Folien aus dielektrischem Keramikmaterial (1 bis 6) herstellt, derart, daß jede Seite einer Folie eine gewisse Anzahl von metallisierten Zonen (7, 8, 9, 10) unterschiedlicher Oberflächen enthält, d. h. die einen mit einfacher Oberfläche und die anderen mit doppelter Oberfläche, die die Platten oder Elektroden von Kondensatoren bilden, wobei die doppelten Oberflächenzonen die Gesamtheit der Reihenplatten zweier aufeinanderfolgender Kondensatoren bilden,

— man stapelt die dünnen metallisierten Folien so übereinander, daß die Platten einander gegenüberliegen,

— man stellt die Verbindungen (11 bis 20) zwischen den verschiedenen parallelen Platten durch eine Metallisierung eines Teils der Außenfläche des monolythischen Kondensatorblocks her,

— man stellt im Raum zwischen den beiden voneinander unabhängigen Gruppen (I, II) von in Reihe geschalteten Kondensatoren einen Spalt oder mehrere Spalte (21, 22, 23) her, die die ganze Länge des Blocks oder einen Teil davon einnehmen, wobei einer der Spalte zur Aufnahme der die Kondensatoren der beiden Gruppen miteinander verbindenden Dioden (CR1 bis CR8) dient und die anderen auf die parasitären Eingangs- und Ausgangskapazitäten des Vervielfachers einwirken,

— man legt nach der sogenannten Dickschicht-Technologie eine Widerstandsschicht auf eine der Seiten des Blocks, die einen Lastwiderstand (45) großer Impedanz darstellt,

— man umhüllt den Block mit einen dünnen Schicht Silikon, Epoxy oder Email.

11. Verfahren nach Anspruch 10, dadurch gekennzeichnet, daß im Raum zwischen den beiden unabhängigen Gruppen von in Reihe geschalteten Kondensatoren Löcher vorgesehen werden, die zur Aufnahme der Dioden (CR1, CR8) dienen.

**0 034 102**

FIG_1

FIG_2

FIG_3

1

# FIG_4

# FIG_5

# FIG_6

# FIG_7